# EUROPEAN PATENT SPECIFICATION

(11) **EP 4 519 141 B1**
(45) Date of publication and mention of the grant of the patent: **04.02.2026**
(21) Application number: 23724007.2
(22) Date of filing: 02.05.2023
(51) Int. Cl.: B60W 60/00

(54) **CONTROLLING AN AUTONOMOUS VEHICLE**
STEUERUNG EINES AUTONOMEN FAHRZEUGS
COMMANDE D'UN VÉHICULE AUTONOME

(30) Priority: 03.05.2022 GB 202206452
(43) Date of publication of application: 12.03.2025
(60) Divisional application: 25181815.9
(73) Proprietor: Oxa Autonomy Ltd, Oxford Oxfordshire OX4 2FL (GB)
(72) Inventor: PORAV, Horia, Oxford Oxfordshire OX4 2HW (GB); UPCROFT, Ben, Oxford Oxfordshire OX4 2HW (GB); NEWMAN, Paul, Oxford Oxfordshire OX4 2HW (GB); STEWART, Alex, Oxford Oxfordshire OX4 2HW (GB)
(74) Representative: Appleyard Lees IP LLP
(86) International application number: PCT/GB2023/051160
(87) International publication number: WO 2023/214159

(56) References cited:
- US-A1- 2018 196 436
- US-A1- 2020 026 296
- US-A1- 2020 278 686
- US-A1- 2021 139 048
- US-A1- 2021 208 596
- US-A1- 2021 387 647
- XU LIHENG ET AL: "Worst Perception Scenario Search for Autonomous Driving", 2020 IEEE INTELLIGENT VEHICLES SYMPOSIUM (IV), IEEE, 19 October 2020 (2020-10-19), pages 1702 - 1707, XP033872685, DOI: 10.1109/IV47402.2020.9304731
- RUI SHU ET AL: "Bottleneck Conditional Density Estimation", ARXIV.ORG, CORNELL UNIVERSITY LIBRARY, 201 OLIN LIBRARY CORNELL UNIVERSITY ITHACA, NY 14853, 25 November 2016 (2016-11-25), XP080734635

## Description

### FIELD

The subject-matter of the present invention relates to a computer a computer-implemented method of controlling an autonomous vehicle, a computer-implemented method of determining a manoeuvring constraint of an autonomous vehicle during a known scenario, and a transitory, or non-transitory, computer-readable medium.

### BACKGROUND

An autonomous vehicle (AV) may capture a plurality of scenarios. Each scenario may be associated with a travel envelope. When the AV encounters a scenario in real time, it is able to traverse within the travel envelope of a matching scenario.

A problem exists where there are no known scenario matches.

It is an aim of the present invention to address such problems and improve on the prior art.

Prior art also includes US2021387647A1 which describes a method for improving the permissiveness of a vehicle designed to operate within an operational design domain ("ODD") where the vehicle has an autonomous vehicle control system capable of collecting sensor data. The method of US2021387647A1, which can be incorporated into a system or into instructions placed on storage media, includes partitioning the ODD into subsets ("micro-ODDs") that relate to different operational situations and creating safety envelopes for those subsets. The safety envelopes are used to keep the vehicle operating safely and can be optimized to improve permissiveness of the vehicular operation.

Prior art also includes US2021139048A1 which describes an autonomous vehicle operated along a route according to a nominal driving solution that takes into account one or more first constraints including a first predicted trajectory for an agent vehicle. An alternate scenario of US2021139048A1 is determined based on one or more second external constraints that include a second predicted trajectory for the agent vehicle different from the first predicted trajectory. A risk factor on the nominal driving solution is determined for the alternative scenario, and a secondary driving solution is determined based on the risk factor and the one or more second external constraints. A candidate switching point of US2021139048A1 is identified where the secondary driving solution diverges from the nominal driving solution, and the nominal driving solution is revised up to the candidate switching point based on the secondary driving solution. The autonomous vehicle of US2021139048A1 is then operated based on the revised nominal driving solution.

Prior art also includes US2021208596A1 which describes a method for controlling an autonomous vehicle to repeatedly follow a same predetermined trajectory comprising: a) receiving a target trajectory signal indicative of the predetermined trajectory; b) generating a control signal adapted to steer the vehicle along the predetermined trajectory; and, for at least one of a number of iterations: c) steering the vehicle along the predetermined trajectory by feeding the control signal to the vehicle; d) measuring an actual trajectory followed by the vehicle in response to being steered according to the control signal; e) recording an actual trajectory signal indicative of the measured actual trajectory; f) using an iterative learning controller to determine an altered control signal using the control signal, the actual trajectory signal and the target trajectory signal. The method of US2021208596A1 allows to improve a tracking performance during a subsequent iteration.

Prior art also includes US2020026296A1 which describes a method for driving dynamics control for a transportation vehicle, wherein a manipulated variable of the driving dynamics is controlled by a control circuit having two degrees of freedom, consisting of a pilot control and a controller, to drive through a planned trajectory, wherein the control circuit has an iteratively learning controller which cyclically repeats classifying the planned trajectory by a classification device, retrieving a manipulated variable profile for the iteratively learning controller from a database based on the classification, recording a control fault of the control circuit and/or a manipulated variable of the controller when driving through the planned trajectory by a memory, and adapting the manipulated variable profile of the iteratively learning controller based on the recorded control fault and/or the recorded manipulated variable of the controller. Also disclosed in US2020026296A1 is an associated device.

Prior art also includes US2020278686A1 which describes establishing a feedback connection between a motion planner and a motion controller in an autonomous driving system wherein feedback is iteratively updated and able to improve motion controller performance.

Prior art also includes US2018196436A1 which describes a method for performing autonomous operation of a vehicle is provided. The method obtains object data, by a plurality of vehicle onboard sensors; obtains road data, by one or more cameras onboard the vehicle; determines, by at least one processor, an initial vehicle trajectory, based on the object data and the road data; identifies, by the at least one processor, a set of constraints associated with the initial vehicle trajectory; determines a final vehicle trajectory, based on the potential vehicle trajectory and the set of constraints; and transmits the final vehicle trajectory to a steering mechanism onboard the vehicle.

Prior art also includes Rui Shu et al: "Bottleneck Conditional Density Estimation", arxiv.org, Cornell University Library, 201 Olin Library Cornell University Ithaca, NY 14853, (2017-06-30), XP080734635.

Prior art also includes Xu Liheng et al: "Worst Perception Scenario Search for Autonomous Driving", 2020 IEEE Intelligent Vehicles Symposium (IV), IEEE, 19 October 2020, pages 1702-1202.

### SUMMARY

According to a non claimed aspect, there is provided a computer-implemented method of controlling an autonomous vehicle. The method comprises: receiving current sensor data defining a current scenario; determining a distance between the current scenario and a closest scenario from a database of known scenarios; and controlling the autonomous vehicle by: manoeuvring the autonomous vehicle within a manoeuvring constraint associated with the closest scenario when the distance is below a first threshold; performing a minimal risk manoeuvre when the distance is above a second threshold, wherein the second threshold is greater than the first threshold; and interpolating the manoeuvring constraint associated with the closest scenario when the distance is between the first threshold and the second threshold, and manoeuvring the autonomous vehicle within the interpolated manoeuvring constraint.

In an embodiment, the current scenario and each known scenario may be a descriptor representing a multivariable distribution from a bottleneck of a variational autoencoder.

In an embodiment, the determining the distance may comprise calculating a distance using a plurality of weighted matchers.

In an embodiment, the plurality of weighted matchers may comprise one or more of: a time warping matcher, a Euclidian distance matcher, and a learned matcher.

In an embodiment, the manoeuvring constraint may comprise a travel envelope constructed in space-time, within which no infractions are predicted to occur.

In an embodiment, the minimal risk manoeuvre may comprise one or more of an emergency stop and pulling over to a road side.

According to an aspect of the invention, there is provided a computer-implemented method of determining a manoeuvring constraint of an autonomous vehicle during a known scenario. The method comprises: running a known scenario of the autonomous vehicle as a simulation in a simulator; iteratively running the simulation by applying different dynamic parameters to the autonomous vehicle; and identifying a maximum dynamic parameter from the different dynamic parameters the autonomous vehicle below which no collisions occur during the simulation and above which a collision occurs during the simulation; and storing, in a constraint database, the maximum dynamic parameter as a manoeuvring constraint of the autonomous vehicle for the known scenario.

In an embodiment, the computer-implemented method further comprises: retrieving a descriptor of the known scenario from a database, the descriptor being a multivariate distribution from a bottleneck of a variational autoencoder; and decoding the descriptor using a decoder from the variational autoencoder to generate the known scenario.

In an embodiment, the iteratively running the simulation may comprise: incrementing and/or decrementing the dynamic parameters; and checking for infractions at each increment and/or decrement.

In an embodiment, the computer-implemented method may further comprise: continuing the incrementing and/or decrementing until modulation of the dynamic parameters has been exhausted.

In an embodiment, the incrementing and/or decrementing may comprise incrementing and/or decrementing at a predefined interval.

In an embodiment, the dynamic parameters may be selected from a list including velocity, acceleration, deceleration, and jerk.

In an embodiment, the manoeuvring constraint comprises a travel envelope constructed in space-time, within which no infractions are predicted to occur.

According to a further aspect of the invention, there is provided a transitory, or non-transitory, computer-readable medium having instructions stored thereon that, when executed by a processor, cause the processor to perform the computer-implemented method of any preceding claim.

### BRIEF DESCRIPTION OF DRAWINGS

The subject-matter of the present disclosure is best described with reference to the accompanying figures, in which:
Figure 1 shows a schematic of an AV according to one or more embodiments;
Figure 2 shows a block diagram of features used by the methods described herein;
Figure 3 shows a block diagram of features used for determining tracking and prediction of objects within a scenario captured by sensors of the AV from Figure 1;
Figure 4 shows a block diagram of features used for determining tracking and prediction of objects within scenes within a simulator;
Figure 5 shows a block diagram of features used for training a scenario encoder;
Figure 6 shows a block diagram of features used for comparing scenarios using the trained scenario encoder from Figure 5;
Figure 7 shows a block diagram of the scenario comparator shown in Figure 6;
Figure 8 shows a flow chart of a method of determining a manoeuvring constraint according to one or more embodiments; and
Figure 9 shows a flow chart of a method of controlling the AV from Figure 1.

### DESCRIPTION OF EMBODIMENTS

The embodiments described herein are embodied as sets of instructions stored as electronic data in one or more storage media. Specifically, the instructions may be provided on a transitory or non-transitory computer-readable media. When executed by the processor, the processor is configured to perform the various methods described in the following embodiments. In this way, the methods may be computer-implemented methods. In particular, the processor and a storage including the instructions may be incorporated into a vehicle. The vehicle may be an AV.

Whilst the following embodiments provide specific illustrative examples, those illustrative examples should not be taken as limiting, and the scope of protection is defined by the claims. Features from specific embodiments may be used in combination with features from other embodiments without extending the subject-matter beyond the content of the present disclosure.

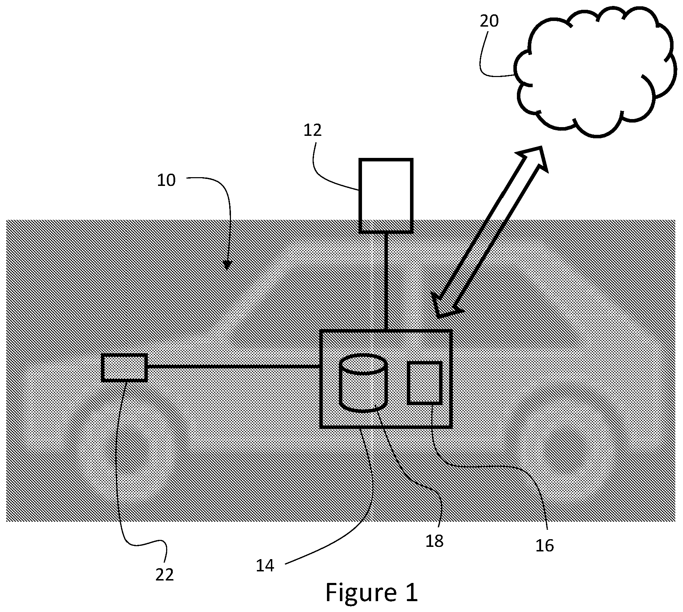

With reference to Figure 1, an AV 10 may include a plurality of sensors 12. The sensors 12 may be mounted on a roof of the AV 10. The sensors 12 may be communicatively connected to a computer 14. The computer 14 may be onboard the AV 10. The computer 14 may include a processor 16 and a memory 18. The memory may include the non-transitory computer-readable media described above. Alternatively, the non-transitory computer-readable media may be located remotely and may be communicatively linked to the computer 14 via the cloud 20. The computer 14 may be communicatively linked to one or more actuators 22 for control thereof to move the AV 10. The actuators may include, for example, a motor, a braking system, a power steering system, etc.

The sensors 12 may include various sensor types. Examples of sensor types include LiDAR sensors, RADAR sensors, and cameras. Each sensor type may be referred to as a sensor modality. Each sensor type may record data associated with the sensor modality. For example, the LiDAR sensor may record LiDAR modality data.

The data may capture various scenes that the AV 10 encounters. For example, a scene may be a visible scene around the AV 10 and may include roads, buildings, weather, objects (e.g. other vehicles, pedestrians, animals, etc.), etc.

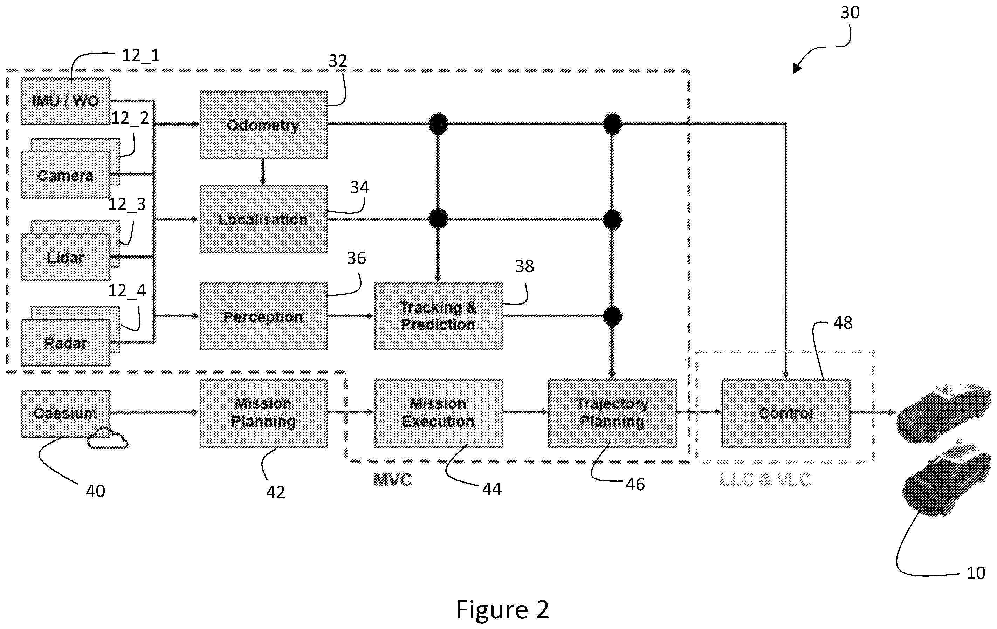

With reference to Figure 2, a vehicle control system 30 comprises the plurality of sensors 12. The plurality of sensors 12 includes an inertial measurement unit (IMU) 12_1, a camera 12_2, a LiDAR sensor 12_3, and a radar sensor 12_4. The vehicle control system 30 also comprises an odometry module 32, a localisation module 34, a perception module 36, and a tracking and prediction module 38. The system 30 also comprises a high-level instruction module 40, a mission planning module 42, a mission execution module 44, a trajectory planning module 46, and a controller 48.

The IMU 12_1 may include an accelerometer and a gyroscope, for example.

The odometry module 32 may be configured to estimate a position of the AV 10 over time relative to a reference point (e.g. a starting point) using inputs from the plurality of sensors 12.

The localisation module 34 may be confirmed to estimate a global pose of the AV 10 within its environment using inputs from the plurality of sensors 12.

The perception module 36 may be configured to generate models of the AV's 10 environment, including objects within the environment. The models may include segmentation maps, bounding boxed, cuboids, depth perception, etc., using inputs from the plurality of sensors 12.

The tracking and prediction module 38 may be configured to track objects (static and dynamic) within a scene based on the outputs from the odometry module 32, the localisation module 34, and the perception module 36.

The high-level instructions module 40 may be configured to receive an input from a user regarding a route, e.g. a destination, and output a command to move the AV 10 from the current location to a destination, e.g. from point A to B.

The mission planning module 42 may include a map, and when in cooperation with the mission planning module 42, may be configured to construct a route that will execute the route from the high-level instructions module 40. The route may be a travel envelope within which the AV 10 must travel to traverse the route successfully.

The trajectory planning module 46 may be configured to plan a trajectory for the AV 10 that is within the travel envelope defined by the mission execution module 44, taking account of objects' trajectories and positions from the tracking and prediction module, and the position of the AV 10 from the odometry and localisation modules 32, 34.

The controller 48 may be configured to control one or more actuators of the AV 10 to implement the trajectory from the trajectory planning module 46.

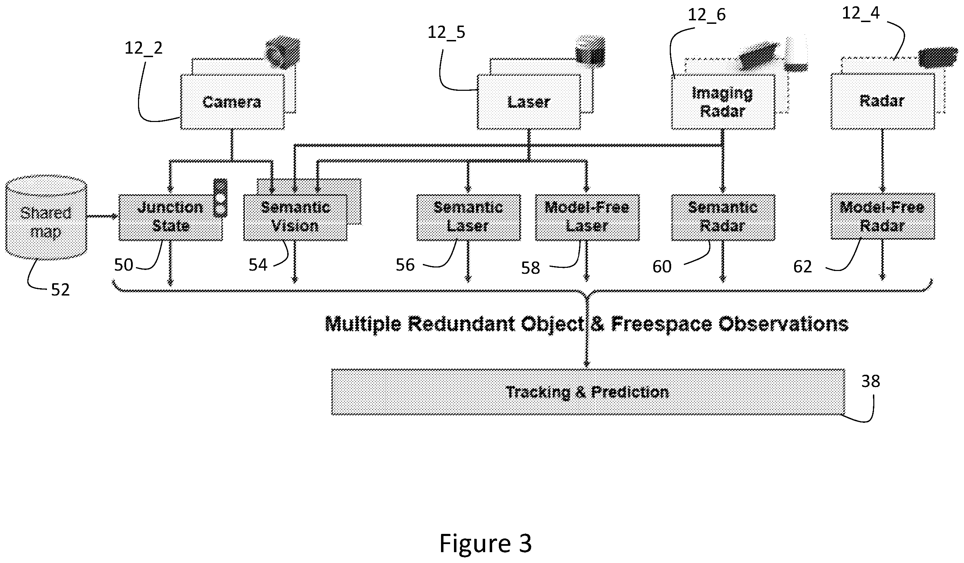

With reference to Figure 3, features from the vehicle control system 30 are shown in more detail. In particular, Figure 3 shows a flow chart for determining the tracking and prediction of objects based on real time, online, sensor data. By online, we mean when the AV 10 is active in its field, or environment.

The sensors 12, including the camera 12_2 and the radar 12_4, may also include a laser 12_5 and an imaging radar 12_6.

The camera 12_2 images may be used to generate a junction state 50 in combination with a shared map 52. A junction may be defined as an area whose access state changes dynamically. By access state we mean whether the AV 10 is able to access to area being controlled. Examples of junctions include traffic lights, pelican crossings, zebra crossings, give-way markings, etc.

The camera 12_2, laser 12_5, and imaging radar 12_6 data, may be used to generate a semantic vision 54. The term semantic used herein may generally refer to something in the form of a class or an embedding. Semantic vision may include embeddings of objects viewed in the visual, camera image, modality.

The laser 12_5 may be used to generate a semantic laser 56. This may mean an embedding associated with laser points in the laser domain.

The laser may also be used to generate a model-free laser 58. The term model-free may generally be used herein to mean raw data points from a particular modality. The model-free laser may be raw laser points.

The imaging radar 12_6 may be used to generate a semantic radar. The semantic radar 60 may be embeddings defining features captured by the imaging radar 12_6. As used herein, the term semantic may mean a first representation processed into a second representation bearing semantic information.

The radar 12_5 may be used to generate a model-free radar 62. The model-free radar may include raw radar points.

The junction state 50, semantic vision 54, semantic laser 56, model-free laser 58, semantic radar 60, and model-free radar 62, may be used to generate the tracking and prediction module 38.

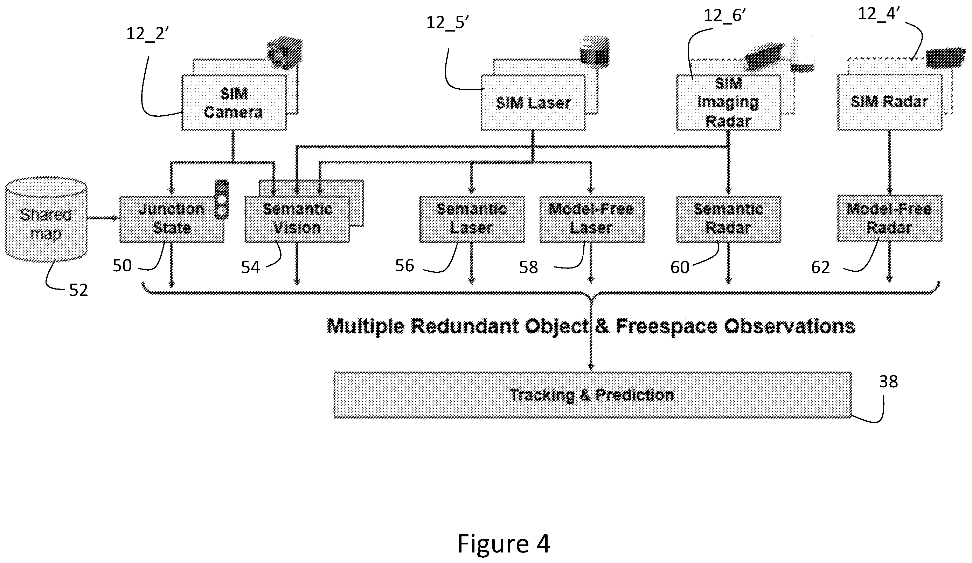

Figure 4 shows a similar diagram to Figure 3, except the inputs are simulated inputs. In this way, the tracking and prediction module 38 uses data from a simulated camera 12_2', a simulated laser 12_5', a simulated imaging radar 12_6', and a simulated radar 12_4'.

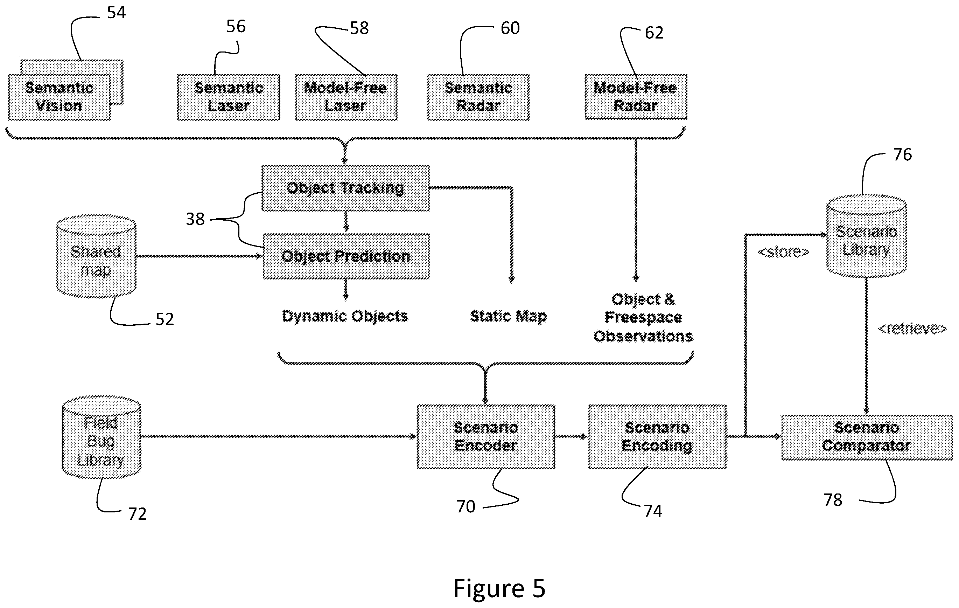

With reference to Figure 5, a flow chart is shown to explain how to train an encoder to generate a scenario encoding.

The tracking and prediction module 38 has determined positions of static objects and positions and trajectories of dynamic objects, which are input together with object and freespace data (derived from model-free data) into a scenario encoder 70. The term freespace is used to mean a travel envelope which avoids infractions. The travel envelope may be in space time. Infractions represent events that either reduce the safety of operation or reduce the perceived quality of operation. In line with the claimed invention, infractions are collisions.

The scenario encoder 70 may receive a further input from a field bug library 72. The field bug library 72 is a database which includes recorded responses of the AV 10 to infractions online. The scenario encoder 70 may be an autoencoder. The autoencoder may be a variational autoencoder (VAE). A multivariable distribution may be extracted at a bottleneck of the VAE and used as a scenario encoding 74.

The scenario encoding 74 may be stored in a scenario library 76.

A scenario comparator 78 may also be provided. The scenario comparator 78 may be configured to compare the scenario encoding 74 to the other known scenarios included in the scenario library 76. The scenario encoder 70 may be trained in a supervised manner to generate scenario encodings 74 which may match known scenarios of the same scene, for example.

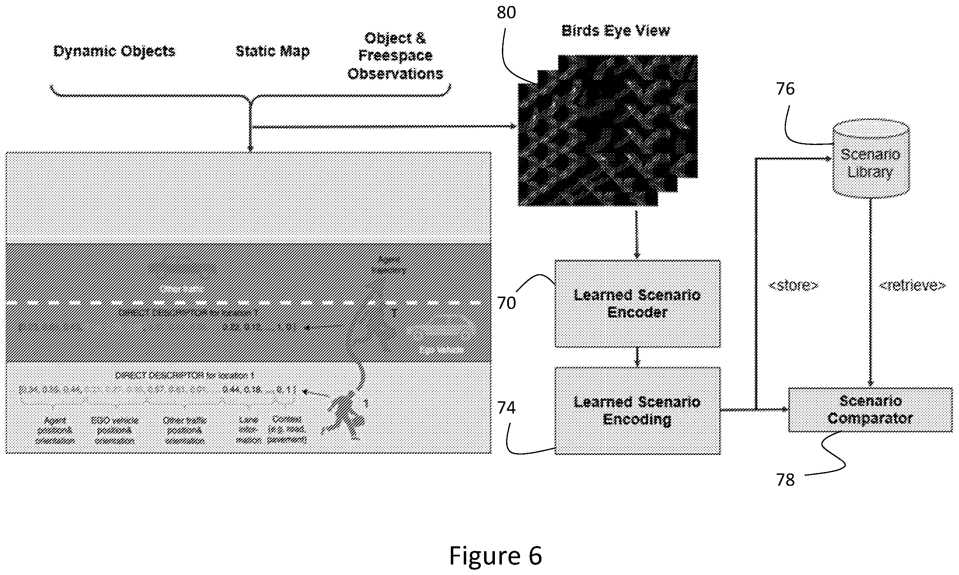

Figure 6 shows a flow chart explaining how additional scenarios are encoded online using the scenario encoder 70 trained by the method outlined with reference to Figure 5.

Online, the dynamic objects, static objects (or static map), and freespace observations, are combined into a bird's eye view 80. The bird's eye view 80 may be a representation of a scene from a reference point. The reference point may be from above. Additionally, the bird's eye view may be constructed entirely from spatio-temporal sensor readings from the AV itself, e.g. single "frame" LIDAR/RADAR scans or multiple scans integrated over time.

The bird's eye view 80 may be used as an input to the learned scenario encoder 70, which generates a scenario encoding 74. The scenario encoding may be compared with known scenarios from the scenario library 76 using the scenario comparator 78.

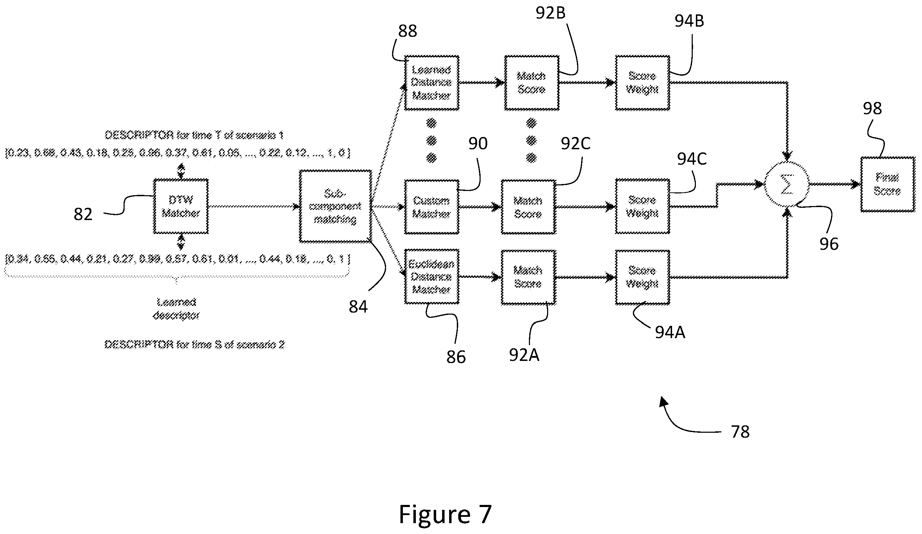

With reference to Figure 7, the scenario comparator 78 is a matcher. The matcher may include a plurality of matching means. For example, a dynamic time warping (DTW) matcher 82 may be used to compare points from each compared encoding in time.

And output from the DTW matcher 82 may be input to a sub-component matcher 84 which distributes the paired points from the DTW matcher 82 to the plurality of matching means. The plurality of matching means each computes a distance between respective points in the pairs.

The matching means may comprises a Euclidian distance matcher 86, a learned distance matcher 88 and a custom matcher 90. The Euclidian distance matcher 86 calculates a Euclidian distance between points of compared encodings. The learned distance matcher 88 may be a neural network trained using contrastive learning to compute a distance between points of compared encodings. The custom matcher may calculate the distance by comparing a hybrid weighted similarity between different heuristics.

The output of the respective matching means is a match score 92A, 92B, 92C. The match score may be a numerical value. A respective score weight 94A, 94B, 94C, may be applied to each match score. The term "apply" may be used to mean multiply. A summation block 96 may add the weighted match scores to generate a final score 98. The score weights may be different. The score weights may be predetermined. In other embodiments, the score weights may be learned. For example, the score weights may be adjusted using an optimisation algorithm on training samples having a desired final score for a particular encoding pair.

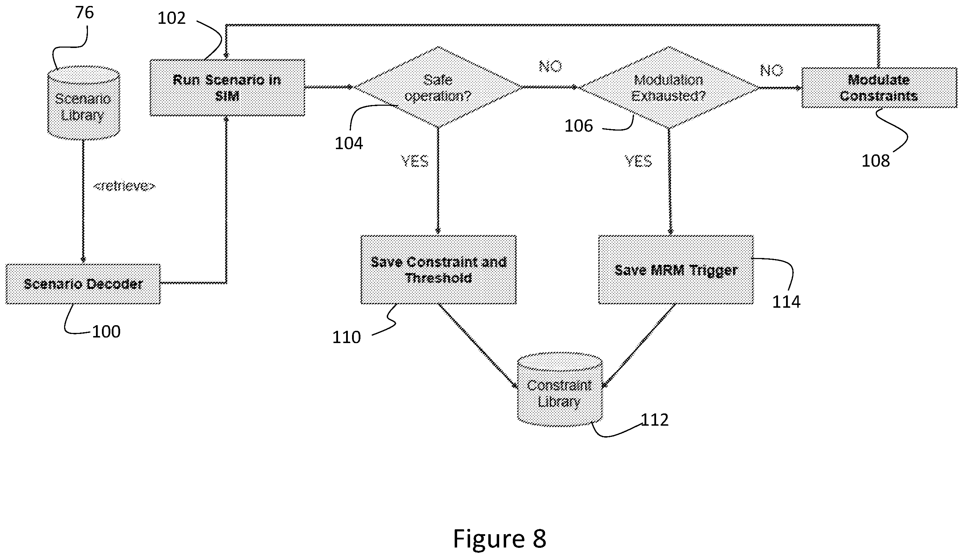

With reference to Figure 8, there is provided a flow chart outlining a computer-implemented method of determining a manoeuvring constraint of an autonomous vehicle during a known scenario according to one or more embodiments.

At step 100, the method comprises retrieving a descriptor of the known scenario from the scenario library 76 stored in a database, the descriptor being a multivariate distribution from a bottleneck of a variational autoencoder as described above. Also at step 100, the descriptor is decoded by a decoder. The decoder may be from the variational autoencoder used to generate the known scenario.

At step 102, the method comprises running the known scenario of the AV as a simulation in a simulator (SIM). The SIM is run iteratively by applying different dynamic parameters to the AV. The dynamic parameters may be selected from a list including velocity, acceleration, deceleration, and jerk.

A first set of dynamic parameters may be applied to the AV in the known scenario. For example, the AV may be travelling at 20 miles per hour (mph) with zero acceleration. At step 104, safe operation of the AV is checked. Safe operation may be understood as meaning that there are no infractions. An infraction may be an event which adversely affects the user's perception of safe driving. Infractions may include collisions with objections within a scenario. Infractions may also include near misses, e.g. where the AV comes within a predetermined distance of another object in the scenario. These examples are non-exhaustive and are included for illustrative purposes only. In line with the claimed invention, infractions are collisions.

If there are infractions, at step 106, the method comprises checking if the dynamic parameters are at their limits. In other words, there is a check to determine if modulation of the dynamic parameters has been exhausted. For example, if the current speed is 20 mph, it is possible to decrement the speed. The decremented (or increments) may be at a predefined interval. The decrements may be at an interval of 5 mph.

At step 108, the method comprises modulating the dynamic parameters. In the above example, the new iteration of speed may be 15 mph.

At step 104, safe operation of the AV is again checked at the new speed iteration, e.g. 15 mph.

The method continues by iteratively running the simulation by incrementing and/or decrementing the dynamic parameters; and checking for infractions at each increment and/or decrement. The method continues incrementing and/or decrementing the dynamic parameters until modulation of the dynamic parameters has been exhausted. For example, the dynamic parameter speed may be exhausted when the speed of the AV is 5 mph.

When step 104 determines that the operation is safe, the maximum dynamic parameter of the AV below which no infractions occur, and above which an infraction occurs, during the SIM, is identified at step 110.

At step 112, the maximum dynamic parameter is stored as a manoeuvring constraint of the AV for the known scenario, in a constraint library. A manoeuvring constraint may comprise a travel envelope constructed in space-time (e.g. using a space-time graph), within which no infractions are predicted to occur.

Otherwise, where the modulation has been exhausted at step 106, the minimum dynamic parameter may be determined as a trigger for initiating a minimal risk manoeuvre (MRM). A minimal risk manoeuvre may include an emergency brake event or pulling to the side of the road, for example. These MR examples are non-exhaustive and are included here for illustrative purposes only.

At step 114, the MRM trigger is identified.

At step 112, the MRM is stored in the constraint library.

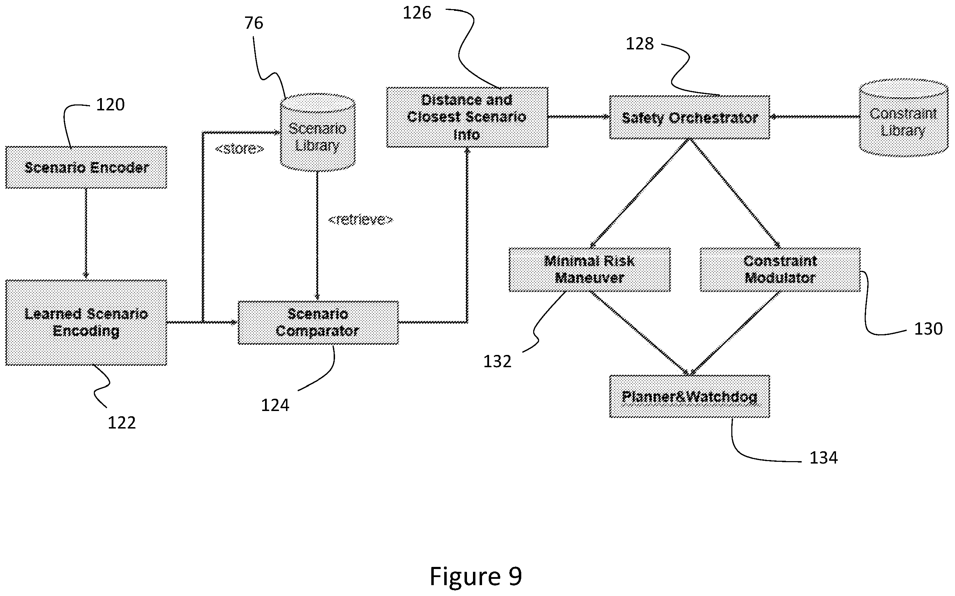

With reference to Figure 9, there is provided a computer-implemented method of controlling an autonomous vehicle according to one or more embodiments.

The method comprises, at step 120, encoding the current scenario using the encoder.

At step 122, the encoding is obtained from the encoded scenario.

At step 124, the encoding of the current scenario is compared with known scenarios from the scenario library. The comparison may be made using the matcher from Figure 7. In this way, determining the distance comprises calculating a distance using a plurality of weighted matchers. The comparisons may be exhaustive in that all known scenarios are compared. In other embodiments, the known scenarios may be clustered in the scenario library using an unsupervised clustering model to group similar scenarios together. In this way, fewer comparisons need to be made.

As described above, the current scenario and each known scenario may be a descriptor representing a multivariable distribution from a bottleneck of a variational autoencoder.

At step 126, the distance between the current scenario and a closest known scenario from the database of known scenarios (scenario library) is determined.

At step 128, a safety orchestrator is used to determine a manoeuvre to be carried out by the AV. The safety orchestrator retrieves the manoeuvring constraint associated with the closest known scenario from the constraint library from Figure 8.

The safety orchestrator may decide it is best to proceed to step 130 and control the AV by manoeuvring the autonomous vehicle within a manoeuvring constraint associated with the closest scenario when the distance is below a first threshold. In other words, the manoeuvring constraint of the closest scenario may be used as the manoeuvring constraint for the current scenario. The manoeuvring constraint may comprise a travel envelope constructed in space-time, within which no infractions are predicted to occur.

The safety orchestrator may decide it is best to control the AV at step 132 by performing a minimal risk manoeuvre when the distance is above a second threshold. The second threshold is greater than the first threshold. The minimal risk manoeuvre may comprise one or more of an emergency stop and pulling over to a road side.

The safety orchestrator may decide it is best to interpolate, again at step 130, the manoeuvring constraint associated with the closest scenario when the distance is between the first threshold and the second threshold and manoeuvre the autonomous vehicle within the interpolated manoeuvring constraint.

Once the mode of implementation (e.g. harvesting the manoeuvring constraint from a closest scenario, interpolation, or by MRM) has been decided, at step 134, a planner determines control instructions for the AV's actuators to implement the mode of implementation. Simultaneously, a watchdog monitors the panner's actions. In certain circumstances, the watchdog may override the planner.

Whilst the foregoing embodiments have been described to illustrate the subject-matter of the present invention, the features of the embodiments are not to be taken as limiting the scope of protection. For the avoidance of doubt, the scope of protection is defined by the following claims.

## Claims

1. A computer-implemented method of determining a manoeuvring constraint of an autonomous vehicle (10) during a known scenario, the method comprising:
running a known scenario of the autonomous vehicle (10) as a simulation in a simulator;
iteratively running the simulation by applying different dynamic parameters to the autonomous vehicle (10); and
identifying a maximum dynamic parameter from the different dynamic parameters the autonomous vehicle (10) below which no collisions occur during the simulation and above which a collision occurs during the simulation; and
storing, in a constraint database, the maximum dynamic parameter as a manoeuvring constraint of the autonomous vehicle (10) for the known scenario.

2. The computer-implemented method of Claim 1, further comprising:
retrieving a descriptor of the known scenario from a database, the descriptor being a multivariate distribution from a bottleneck of a variational autoencoder (70); and
decoding the descriptor using a decoder from the variational autoencoder (70) to generate the known scenario.

3. The computer-implemented method of Claim 1 or Claim 2 wherein the iteratively running the simulation comprises:
incrementing and/or decrementing the dynamic parameters; and
checking for infractions at each increment and/or decrement.

4. The computer-implemented method of Claim 3, further comprising:
continuing the incrementing and/or decrementing until modulation of the dynamic parameters has been exhausted.

5. The computer-implemented method of Claim 3 or Claim 4, wherein the incrementing and/or decrementing comprises incrementing and/or decrementing at a predefined interval.

6. The computer-implemented method of any of Claims 1 to 5, wherein the dynamic parameters are selected from a list including velocity, acceleration, deceleration, and jerk.

7. The computer-implemented method of any of Claims 1 to 6, wherein the manoeuvring constraint comprises a travel envelope constructed in space-time, within which no infractions are predicted to occur.

8. A transitory, or non-transitory, computer-readable medium having instructions stored thereon that, when executed by a processor, cause the processor to perform the computer-implemented method of any preceding claim.

## Patentansprüche

1. Computerimplementiertes Verfahren zur Bestimmung einer Manövrierbeschränkung eines autonomen Fahrzeugs (10) während eines bekannten Szenarios, wobei das Verfahren Folgendes umfasst:
Abspielen eines bekannten Szenarios des autonomen Fahrzeugs (10) als eine Simulation in einem Simulator;
iteratives Abspielen der Simulation unter Anlegung unterschiedlicher dynamischer Parameter an das autonome Fahrzeug (10); und
Ermitteln eines maximalen dynamischen Parameters aus den unterschiedlichen dynamischen Parametern das autonome Fahrzeug (10), unter dem es während der Simulation nicht zu Kollisionen kommt und über dem es während der Simulation zu einer Kollision kommt; und
Speichern - in einer Beschränkungsdatenbank - des maximalen dynamischen Parameters als eine Manövrierbeschränkung des autonomen Fahrzeugs (10) für das bekannte Szenario.

2. Computerimplementiertes Verfahren nach Anspruch 1, ferner umfassend:
Abrufen eines Deskriptors des bekannten Szenarios aus einer Datenbank, wobei der Deskriptor eine mehrdimensionale Verteilung von einem Bottleneck eines Variational Autoencoders (70) ist; und
Decodieren des Deskriptors unter Verwendung eines Decoders von dem Variational Autoencoder (70), um das bekannte Szenario zu erzeugen.

3. Computerimplementiertes Verfahren nach Anspruch 1 oder Anspruch 2, wobei das iterative Abspielen der Simulation Folgendes umfasst:
Inkrementieren und/oder Dekrementieren der dynamischen Parameter; und
Prüfen auf Verstöße bei jedem Inkrement und/oder Dekrement.

4. Computerimplementiertes Verfahren nach Anspruch 3, ferner umfassend:
Fortsetzen des Inkrementierens und/oder Dekrementierens, bis die Modulation der dynamischen Parameter ausgeschöpft worden ist.

5. Computerimplementiertes Verfahren nach Anspruch 3 oder Anspruch 4, wobei das Inkrementieren und/oder Dekrementieren ein Inkrementieren und/oder Dekrementieren in einem vordefinierten Intervall umfasst.

6. Computerimplementiertes Verfahren nach einem der Ansprüche 1 bis 5, wobei die dynamischen Parameter aus einer Liste, die Geschwindigkeit, Beschleunigung, Verzögerung und Ruck umfasst, ausgewählt sind.

7. Computerimplementiertes Verfahren nach einem der Ansprüche 1 bis 6, wobei die Manövrierbeschränkung einen in Raum und Zeit konstruierten Fahrschlauch umfasst, innerhalb dessen es vorhersagegemäß nicht zu Verstößen kommt.

8. Flüchtiges oder nichtflüchtiges computerlesbares Medium, auf dem Anweisungen gespeichert sind, die, wenn sie durch einen Prozessor ausgeführt werden, bewirken, dass der Prozessor das computerimplementierte Verfahren nach einem vorangehenden Anspruch durchführt.

## Revendications

1. Procédé, mis en œuvre par ordinateur, de détermination d'une contrainte de manœuvre d'un véhicule autonome (10) au cours d'un scénario connu, le procédé comprenant :
l'exécution d'un scénario connu du véhicule autonome (10) sous forme d'une simulation dans un simulateur ;
l'exécution itérative de la simulation par application de différents paramètres dynamiques au véhicule autonome (10) ; et
l'identification d'un paramètre dynamique maximal parmi les différents paramètres dynamiques le véhicule autonome (10) en dessous duquel aucune collision ne se produit au cours de la simulation et au-dessus duquel une collision se produit au cours de la simulation ; et
le stockage, dans une base de données de contraintes, du paramètre dynamique maximal en tant que contrainte de manœuvre du véhicule autonome (10) pour le scénario connu.

2. Procédé mis en œuvre par ordinateur selon la revendication 1, comprenant en outre :
la récupération d'un descripteur du scénario connu à partir d'une base de données, le descripteur étant une distribution multivariée issue d'un goulot d'étranglement d'un auto-encodeur variationnel (70) ; et
le décodage du descripteur à l'aide d'un décodeur de l'auto-encodeur variationnel (70) afin de générer le scénario connu.

3. Procédé mis en œuvre par ordinateur selon la revendication 1 ou la revendication 2, dans lequel l'exécution itérative de la simulation comprend :
l'incrémentation et/ou la décrémentation des paramètres dynamiques ; et
la recherche d'infractions à chaque incrément et/ou décrément.

4. Procédé mis en œuvre par ordinateur selon la revendication 3, comprenant en outre :
la poursuite de l'incrémentation et/ou de la décrémentation jusqu'à l'épuisement de la modulation des paramètres dynamiques.

5. Procédé mis en œuvre par ordinateur selon la revendication 3 ou la revendication 4, dans lequel l'incrémentation et/ou la décrémentation comprend l'incrémentation et/ou la décrémentation selon un intervalle prédéfini.

6. Procédé mis en œuvre par ordinateur selon l'une quelconque des revendications 1 à 5, dans lequel les paramètres dynamiques sont sélectionnés dans une liste comprenant une vitesse, une accélération, une décélération, et un à-coup.

7. Procédé mis en œuvre par ordinateur selon l'une quelconque des revendications 1 à 6, dans lequel la contrainte de manœuvre comprend une enveloppe de déplacement construite dans l'espace-temps, au sein de laquelle la survenue d'aucune infraction est prédite.

8. Support transitoire, ou non transitoire, lisible par ordinateur sur lequel sont stockées des instructions qui, lorsqu'elles sont exécutées par un processeur, amènent le processeur à réaliser le procédé mis en œuvre par ordinateur selon l'une quelconque des revendications précédentes.
